# EUROPEAN PATENT SPECIFICATION

(11) **EP 2 251 461 B1**
(45) Date of publication and mention of the grant of the patent: **14.06.2017**
(21) Application number: 09718815.5
(22) Date of filing: 10.03.2009
(51) Int. Cl.: C30B 15/10, C03B 20/00

(54) **PROCESS FOR PRODUCING A QUARTZ GLASS CRUCIBLE**
HERSTELLUNGSVERFAHREN EINES QUARZGLASTIEGELS
PROCÉDÉ DE FABRICATION D'UN CREUSET EN VERRE DE SILICE

(30) Priority: 14.03.2008 JP 2008065148
(43) Date of publication of application: 17.11.2010
(73) Proprietor: Japan Super Quartz Corporation, Akita city Akita 010-0065 (JP)
(72) Inventor: HARADA, Kazuhiro, Akita-shi Akita 010-0065 (JP); SATO, Tadahiro, Akita-shi Akita 010-0065 (JP)
(74) Representative: Gulde & Partner
(86) International application number: PCT/JP2009/054521
(87) International publication number: WO 2009/113525

(56) References cited:
- JP-A- 7 196 397
- JP-A- 61 242 984
- JP-A- H07 196 397
- JP-A- 2005 145 732
- JP-A- 2005 145 732
- JP-A- 2005 231 986
- JP-A- 2005 343 707
- JP-A- 2006 124 235
- US-B1- 6 652 934

## Description

### TECHNICAL FIELD

The present invention relates to a method of manufacturing a vitreous silica crucible used for pulling silicon single crystals. The vitreous silica crucible has a high OH group concentration in a region near the inner surface, and the concentration decreases as a distance from the inner surface increases.

### BACKGROUND ART

Silicon single crystals used for substrates of semiconductor devices, solar cells, and so on are primarily manufactured by the CZ method. This is a method where highly-pure polycrystalline silicon melt is charged into a vitreous silica crucible, and silicon single crystals are pulled under an inactive gas atmosphere.

Nowadays, in accordance with increase in opening diameter of silicon single crystals, large-size crucibles are used. Because a large amount of polycrystalline silicon is charged in the large-size crucible, crucible temperature during pulling has been increased. This brings about increase in melting loss of the crucible inner surface, and decrease in crucible viscosity. This increase in melting loss and decrease in viscosity inhibits long-time use of the crucible.

In order to prevent deformation of the crucible due to the melting loss of the crucible inner surface and decrease in viscosity, there has been proposed a vitreous silica crucible in which the inner surface is devitrified during pulling (Patent Document-1: Japanese Patent Application Laid-Open Hei 9-110579 etc.). However, when barium (Ba) is applied to the inner surface or alkali metal or alkali earth metal is added in order to devitrify (crystallize) the inner surface during melting polysilicon, contamination of silicon single crystals caused by the impurities can cause problems.

Here, there has been proposed a method to promote crystallization by increasing an OH group concentration in the inner surface layer of the crucible (Patent Document 2: Japanese Patent Application Laid-Open 2005-145732, Patent Document 3: WO-00/06811). In a crucible of Patent Document 2, at least, an OH group concentration in a range of 10 µm and 200 µm from the inner surface is controlled to 250 ppm to 650 ppm. Furthermore, in a crucible of Patent Document 3, an OH group concentration in the inner layer is adjusted to 50 ppm to 250 ppm. Patent document US 6,652,934 B1 discloses a method of making a silica glass crucible by arc fusion of silica powder, whereby helium or argon gas is supplied to the inner side of the crucible and hydrogen gas is supplied at a later stage of the melting process.
Patent Document 1: Japanese Patent Application Laid-Open Hei 9-110579
Patent Document 2: Japanese Patent Application Laid-Open 2005-145732
Patent Document 3: International Publication WO-00/06811

### DISCLOSURE OF THE INVENTION

### Problems to be Solved by the Inventions

It is known that the crystallization caused by contact between silicon melt and an inner surface of a crucible occur more easily as the OH group concentration of the inner surface increases. However, there is a problem that as the OH group concentration of the inner surface increases, the viscosity of vitreous silica decreases and the vitreous silica deforms more easily. Especially, for a large-size crucible, a larger amount of polycrystalline silicon is charged than that for a small-size crucible, and therefore melting time is lengthened and the crucible temperature is increased. In addition, the inner layer of the crucible having a high OH group concentration is not easily devitrified when there is no silicon melt therein before the polycrystalline silicon is melted to produce silicon melt, and the possibility of deformation is increased because of the high OH group concentration.

The present invention solves the above-mentioned problem which exists in a conventional vitreous silica crucible having a high OH group concentration, and provides a vitreous silica crucible which enables, during pulling, crystallization promotion of the inner surface and retention of the crucible strength. This crucible is formed so as to have an OH group concentration gradient where the OH group concentration increases as a distance from the inner surface decreases, and the OH group concentration rapidly decrease as the distance increases.

### Means for Solving the Problems

The present invention relates to a method of manufacturing a vitreous silica crucible as defined in claim 1.

### EFFECT OF THE INVENTION

A vitreous silica crucible made according to the process of the invention has, in at least a portion of a straight body section of a crucible, a region between 0.3 mm and 3 mm from the crucible inner surface having an OH group concentration and an OH group concentration gradient which increase as a distance from the inner surface decreases. Therefore, the inner surface contacting silicon melt becomes easily crystallized. On the other hand, an OH group concentration and an OH group concentration gradient of the region decrease as a distance from the inner surface increases, and therefore the viscosity of the vitreous silica is large and the crucible is hard to be deformed at high temperature.

Specifically, in a vitreous silica crucible made according to the process of the present invention, a region between 0.3 mm and 0.5 mm from the crucible inner surface has an OH group concentration of 115 ppm or more, a region between 0.3 mm and 0.5 mm has an OH group concentration gradient of 100 ppm/mm or more, and a region between 1.0 mm and 3.0 mm from the crucible inner surface has an OH group concentration gradient of 25 ppm/mm or less.

As shown in the above OH group concentration distribution and concentration gradient, in a region between 0.3 mm and 0.5 mm from the crucible inner surface, the OH group concentration rapidly increases as a distance from the inner surface decreases, while the OH group concentration gradually decreases as distance from the inner surface increases. Specifically, for example, (a) a region between 0.3 mm and 0.5 mm from the crucible inner surface has an OH group concentration gradient of 100 ppm/mm or more, and a portion or the whole of a region up to 0.5 mm from the crucible inner surface has an OH group concentration of 115 ppm or more, (b) a region between 0.5 mm and 1.0 mm from the crucible inner surface has an OH group concentration gradient of 50 ppm/mm or more, (c) a region between 1.0 mm and 2.0 mm from the crucible inner surface has an OH group concentration gradient of 25 ppm/mm or less and an OH group concentration of 105 ppm or less, and (d) a region between 2.0 mm and 3.0 mm from the crucible inner surface has an OH group concentration gradient of 20 ppm/mm or less and an OH group concentration of 80 ppm or less.

Thus, because the OH group concentration rapidly increases as a distance from the inner surface decreases, and the OH group concentration is 115 ppm or more, and is preferably 130 ppm or more, a crucible surface is easily crystallized due to contact with silicon melt. On the other hand, in a region of 1.0mm or more from the crucible inner surface, the OH group concentration is sufficiently law, and therefore the viscosity of the vitreous silica does not rapidly decrease at high temperature, the crucible remains strong, and the deformation is hard to occur.

A manufacturing method of the present invention includes the step of heating and melting silica powder deposited on an inner surface of a rotating mold to vitrify the silica powder, wherein vapor-containing air is introduced right after the melting. By this method, a vitreous silica crucible having the above OH group concentration and OH group concentration gradient can be manufactured by introducing vapor-containing air right after the melting.

### BRIEF DESCRIPTION OF THE DRAWINGS

Fig. 1 shows a sectional view schematically illustrating a structure of a vitreous silica crucible prepared according to the invention.
Fig. 2 shows a graph illustrating OH group concentration distribution in a region near the crucible inner surface.
Fig. 3 shows a flowchart schematically illustrating a manufacturing process of a vitreous silica crucible, according to the present embodiment.
Fig. 4 shows an explanation drawing illustrating a measurement method of the deformation amount of a crucible.

### EXPLANATION OF REFERENCE SYMBOL

- 10: vitreous silica crucible
- 10A: straight body section of the crucible
- 10B: bottom section of the crucible
- 10C: corner section of the crucible
- 11: opaque vitreous silica layer
- 12: transparent vitreous silica layer

### BEST EMBODIMENT FOR CARRYING OUT THE INVENTION

Hereinafter, the present invention will be specifically explained based on an embodiment shown in the drawings.

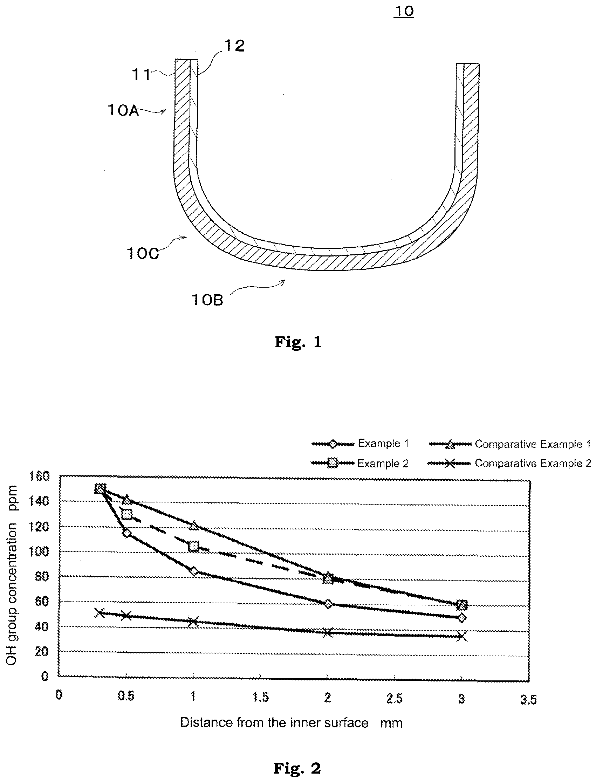

Fig. 1 shows a sectional view schematically illustrating a structure of a vitreous silica crucible prepared according to the present invention.

As shown in Fig. 1, a vitreous silica crucible 10 is used for pulling silicon single crystals, and includes a straight body section 10A, a bottom section 10b, and a corner section 10C. The straight body section 10A is a vertical section constituting a cylindrical sidewall, but it does not need to be perfectly vertical, and it can be, for example, gradually widened toward the opening. Furthermore, it can be linear or gradually curved. The straight body section can be defined as, but not limited to, a region where a tangential tilt angle of the crucible wall surface with respect to a plane orthogonally crossing the central axis of the crucible is 80 degrees or more.

The bottom section 10b is a section constituting a bottom wall orthogonally crossing the central axis of the crucible. The corner section 10C is a curved section positioned between the straight body section 10A and the bottom section 10b. The bottom section 10b may have a shape with a round bottom or a flat bottom. The curvature or the angle of the corner section 10C may be discretionarily set. When the crucible bottom section 10b has a round bottom, the bottom section 10b has a certain curvature, and therefore the difference in curvature between the bottom section 10b and the corner section 10C is much smaller than that when the crucible bottom section 10b has a flat bottom. When the crucible bottom section 10b has a flat bottom, the bottom section 10b has a flat or extremely slightly curved surface, and the curvature of the corner section 10C is very large.

The wall thickness of the crucible is preferably 10 mm or more, because a large-size crucible is required to resist long-time operation, and therefore a certain level of thickness is necessary. Especially, a large-size crucible with a diameter of 32 inches (an opening diameter of about 800 mm) or more is preferred to have a wall thickness of 10 mm or more, and a large-size crucible with a diameter of 40 inches (an opening diameter of about 1000 mm) or more is preferred to have a wall thickness of 13 mm or more.

The vitreous silica crucible 10 is preferred to include an opaque vitreous silica layer 11 provided on the crucible outer surface side and incorporating a large number of microbubbles, and a transparent vitreous silica layer 12 provided on the crucible inner surface side and hardly incorporating bubbles. The opaque vitreous silica layer 11 enables heat from a heater placed on the crucible periphery to be uniformly conducted to silicon melt in the vitreous silica crucible. The transparent vitreous silica layer 12 provided near the crucible inner surface can prevent drop in single crystallization rate which is caused by thermal expansion of the bubbles near the inner surface during heating for pulling a silicon single crystal, the resultant partial peeling off of the crucible inner surface to produce silica pieces, and the resultant mix-in of the silica pieces into the single crystal. The vitreous silica crucible 10 may be formed to include an inner layer made of synthetic silica and an outer layer made of natural quartz, or the whole of the crucible may be formed of natural quartz.

In the vitreous silica crucible 10 made according the process of the present invention, the OH group concentration and the OH group concentration gradient increase as a distance from the inner surface decreases, and decrease as a distance from the inner surface increases. At least a portion of the straight body section 10A of the crucible needs to have such OH group concentration and OH group concentration gradient. However, as long as this condition is satisfied, the whole of the straight body section 10A may have such OH group concentration and concentration gradient, or only the main portion of the straight body section 10A may have such OH group concentration and concentration gradient. Furthermore, not only the straight body section 10A, but also the corner section 10C may have such OH group concentration and concentration gradient, and the whole of the crucible including the straight body section 10A, the corner section 10, and the bottom section 10b may have such OH group concentration and concentration gradient.

Fig. 2 shows an OH group concentration distribution of the straight body section of vitreous silica crucibles (Examples 1 and 2). An OH group concentration distribution of the straight body section of vitreous silica crucibles of comparative examples (Comparative examples 1 and 2) is also shown in Fig. 2.

In general, an OH group concentration in a vitreous silica crucible can be measured by an infrared spectroscopic analysis. Specifically, first, a vitreous silica piece is cut out from the vitreous silica crucible, and used as an original form of a measurement sample. This original form of a measurement sample is processed so as to be a flat plate, and the front and rear surfaces thereof are polished to obtain a measurement sample. Next, Using an infrared spectrophotometer (an optical transmittance measurement device), the front surface of the measurement sample is irradiated with infrared light, the transmitted light out of the rear surface of the measurement sample is received, an infrared light absorption peak associated with OH groups in the measured infrared light absorption spectrum is selected, and the transmittance at the peak is compared with the transmittance at wavelength free of infrared light absorption, to calculate an OH group concentration in the measurement sample.

Therefore, the measurement value plotted at a position of 0.3 mm in the X axis is a value obtained by cutting out a measurement sample of a vitreous silica piece having a thickness of 0.3 mm or more from the crucible inner surface, processing the measurement sample in a way as mentioned above, and performing measurement by the above-mentioned spectroscopic analysis. So, this value indicates the concentration of OH groups contained in a vitreous silica portion of a region from the inner surface (0 mm) to 0.3 mm. Likewise, the measurement value plotted at a position of 0.5 mm indicates the concentration of OH groups contained in a vitreous silica portion of a region from 0.3 mm to 0.5 mm. Furthermore, the measurement value plotted at a position of 1 mm in the X axis indicates the concentration of OH groups contained in a vitreous silica portion of a region from 0.5 mm to 1 mm, the measurement value plotted at a position of 2 mm indicates the concentration of OH groups contained in a vitreous silica portion of a region from 1 mm to 2 mm, and the measurement value plotted at a position of 3 mm indicates the concentration of OH groups contained in a vitreous silica portion of a region from 2 mm to 3 mm. An OH group concentration gradient is indicated by a tilt of a straight line between respective points in Fig. 2.

As shown in Fig. 2, in at least a portion of a straight body section of a vitreous silica crucible made according to the process of the present invention, a region between 0.3 mm and 3 mm from the crucible inner surface has an OH group concentration and an OH group concentration gradient which increase as a distance from the inner surface decreases and which decrease as a distance from the inner surface increase.

Specifically, as shown in the drawing, a region between 0.3 mm and 0.5 mm from the crucible inner surface has an OH group concentration of 115 ppm or more, a region between 0.3 mm and 0.5 mm has an OH group concentration gradient of 100 ppm/mm or more, and a region between 1.0 mm and 3.0 mm from the crucible inner surface has an OH group concentration gradient of 25 ppm/mm or less.

When a region between 0.3 mm and 0.5 mm from the crucible inner surface has an OH group concentration of less than 115 ppm, crystallization of the inner surface contacting silicon melt will be insufficient. Furthermore, when the region has an OH group concentration gradient of less than 100 ppm/mm, a region distant from the inner surface will have a high OH group concentration, and therefore the viscosity of the crucible will decrease. Thus, such gradient is not preferred.

Furthermore, when a region between 1.0 mm and 3.0 mm from the crucible inner surface has an OH group concentration gradient of more than 25 ppm/mm, it will be difficult to maintain a low OH group concentration in the region.

As shown in the drawing, a vitreous silica crucible made according to the process of the present invention preferably has the following OH group concentration distribution and OH group concentration gradient.
(a) a region between 0.3 mm and 0.5 mm from the crucible inner surface has an OH group concentration gradient of 100 ppm/mm or more, and a region between 0.3 mm and 0.5 mm from the crucible inner surface has an OH group concentration of 115 ppm or more.
(b) a region between 0.5 mm and 1.0 mm from the crucible inner surface has an OH group concentration gradient of 50 ppm/mm or more.
(c) a region between 1.0 mm and 2.0 mm from the crucible inner surface has an OH group concentration gradient of 25 ppm/mm or less and an OH group concentration of 105 ppm or less.
(d) a region between 2.0 mm and 3.0 mm from the crucible inner surface has an OH group concentration gradient of 20 ppm/mm or less and an OH group concentration of 80 ppm or less.

Here, in the segment of the above-mentioned region, the temperature gradient is defined from 0.3 mm, not from the crucible inner surface 0 mm. This is because the OH group concentration is measured as a concentration in vitreous silica having a certain thickness, and it is not possible to measure the concentration only on the surface. In addition, the OH group concentration within 0.3 mm from the inner surface needs only to be high, and therefore the concentration can be, for example, constant.

Furthermore, as apparent from Fig. 2, an OH group concentration gradient decreases as a distance from the inner surface increases, and therefore a region from 3.0 mm or more from the crucible inner surface is preferred to have an OH group concentration of 60 ppm or less. Especially, a region between 3.0 mm and 0.8t (t is the wall thickness of the crucible) from the inner surface is preferred to have an OH group concentration of 60 ppm or less.

When the conditions about the above-mentioned OH group concentration distribution and OH group concentration gradient are satisfied, the OH group concentration and OH group concentration gradient increase as a distance from the crucible inner surface decreases, and decrease as a distance from the crucible inner surface increases. In addition, difference in OH group concentration increases in proportion to a distance from the crucible inner surface as a distance from the crucible inner surface decreases. Thus, it is possible to maintain a high OH group concentration in a region near the inner surface and decrease an OH group concentration as a distance from the crucible inner surface increases.

Therefore, because a vitreous silica crucible having the above-mentioned OH group concentration distribution and OH group concentration gradient has an OH group concentration which increases as a distance from the crucible inner surface decreases, the inner surface is easily crystallized and the crystallization is promoted when the inner surface is in contact with silicon melt. On the other hand, an OH group concentration rapidly decreases as a distance from the inner surface increases, and a region of 1.0 mm or more from the inner surface has an OH group concentration of 100 ppm or less, and a region of 2.0 mm or more from the inner surface has an OH group concentration of 80 ppm or less, and therefore, the viscosity of the vitreous silica is sufficiently high at high temperature. Therefore, when polycrystalline silicon charged into the crucible is melt, during high-temperature heating to form silicon melt, the crucible remains sufficiently strong.

A method of manufacturing a vitreous silica crucible according to the present invention includes the step of heating and melting silica powder deposited on an inner surface of a rotating mold to vitrify the silica powder, wherein vapor-containing air is introduced right after the melting.

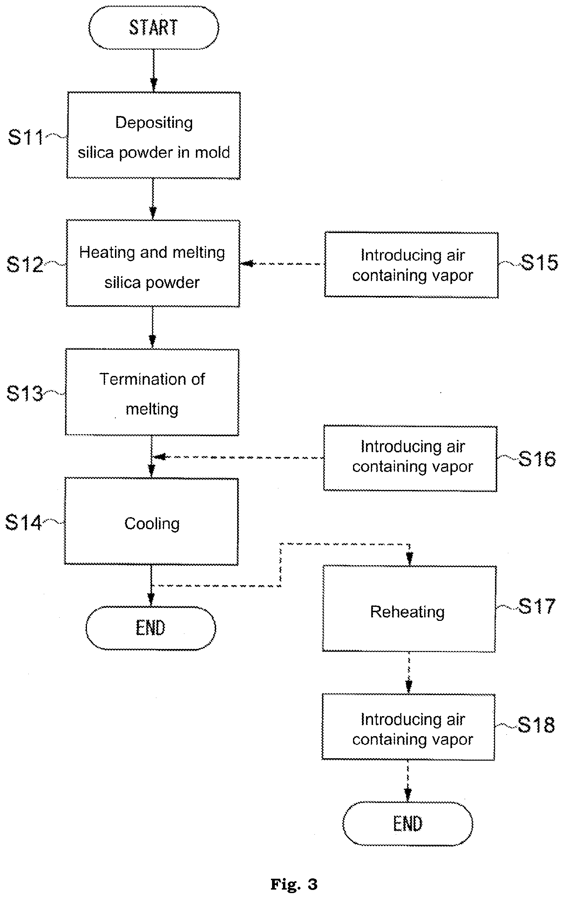

Fig. 3 shows a flowchart schematically illustrating a manufacturing process of a vitreous silica crucible, according to the present embodiment.

As shown in Fig. 3, in a manufacturing process of a vitreous silica crucible, silica powder is deposited on an inner surface of a rotating mold (S11), the silica powder is arc melted to be vitrified (S12), followed by cooling to complete the process (S13, S14). Here, vapor-containing air may be introduced at the melting to produce the vitreous silica crucible (S 15) (not falling under the present invention), or it may be introduced after the melting and cooling (S16), or vapor may be introduced into the atmosphere during heat treatment after the melting (S 17, S18) (not falling under the present invention). It is possible to manufacture the above vitreous silica crucible by adjusting the amount of vapor so as to obtain the above the OH group concentration distribution and OH group concentration gradient.

### Example

### [Example 1]

A synthetic fused silica crucible (opening diameter of 32 inches) having an inner layer made of synthetic fused silica and an outer layer made of highly-pure natural fused silica was, right after heating and melting, treated in a heating and melting furnace where air with a relative humidity of 70 % and a temperature of 25 °C was introduced for 10 minutes at a flow rate of 120 m³ / min. from an inlet provided on a wall of the heating and melting furnace to adjust the OH group concentration of the crucible straight body section (from the upper end of the crucible to a position of 40 % of the crucible height) to have distribution shown in Table 1 and Fig. 2.

### [Example 2]

A synthetic fused silica crucible (opening diameter of 32 inches) having an inner layer made of synthetic fused silica and an outer layer made of highly-pure natural fused silica was, after heating and melting, treated in a heating and melting furnace where air with a relative humidity of 70 % and a temperature of 25 °C was introduced for 20 minutes at a flow rate of 80 m³ / min. from an inlet provided on a wall of the heating and melting furnace to adjust the OH group concentration of the crucible straight body section (from the upper end of the crucible to a position of 40 % of the crucible height) to have distribution shown in Table 1 and Fig. 2.

### [Comparative Example 1]

A synthetic fused silica crucible (opening diameter of 32 inches) having an inner layer made of synthetic fused silica and an outer layer made of highly-pure natural fused silica was, after heating and melting, treated in a heating and melting furnace where air with a relative humidity of 80 % and a temperature of 25 °C was introduced for 20 minutes at a flow rate of 80 m³ / min. from an inlet provided on a wall of the heating and melting furnace to adjust the OH group concentration of the crucible straight body section (from the upper end of the crucible to a position of 40 % of the crucible height) to have distribution shown in Table 1 and Fig. 2.

### [Comparative Example 2]

A synthetic fused silica crucible (opening diameter of 32 inches) having an inner layer made of synthetic fused silica and an outer layer made of highly-pure natural fused silica was, after heating and melting, treated in a heating and melting furnace where air with a relative humidity of 40 % and a temperature of 25 °C was introduced for 20 minutes at a flow rate of 120 m³ / min. from an inlet provided on a wall of the heating and melting furnace to adjust the OH group concentration of the crucible straight body section (from the upper end of the crucible to a position of 40 % of the crucible height) to have distribution shown in Table 1 and Fig. 2.

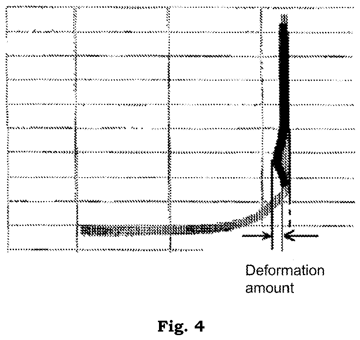

A silicon single crystal with a diameter of about 300 mm was pulled using a crucible of Examples 1 to 2 and Comparative Examples 1 to 2. The resultant deformation amount of the crucible and crystallization state (whether or not devitrification has occurred.) are shown in Table 1. The method of measuring a deformation amount was shown in Fig. 4. The deformation amount is an amount of protrusion from a crucible wall straight section.

As shown in Table 1, in both of Examples 1 and 2, the inner surface was crystallized, the deformation amount was 1.5 mm or less, and therefore it was confirmed that the crucible is hard to be deformed. On the other hand, in Comparative Examples 1 and 2, the inner surface was crystallized, but the deformation amount was 2 mm, and therefore it was confirmed that the deformation amount is large.

**[Table 1]**

| | OH group concentration | | | | | OH group concentration gradient | | | | devitrification | deformation amount (mm) |
|---|---|---|---|---|---|---|---|---|---|---|---|
| distance from the inner surface (mm) | 0.3 | 0.5 | 1.0 | 2.0 | 3.0 | 0.3 to 0.5 | 0.5 to 1.0 | 1.0 to 2.0 | 2.0 to 3.0 | | |
| Example 1 | 150 | 115 | 85 | 60 | 50 | 175 | 60 | 25 | 10 | occurred | 1.0 |
| Example 2 | 150 | 130 | 105 | 80 | 60 | 100 | 50 | 25 | 20 | occurred | 1.5 |
| Comparative Example 1 | 150 | 142 | 122 | 82 | 60 | 40 | 40 | 40 | 22 | occurred | 2.0 |
| Comparative Example 2 | 51 | 49 | 45 | 37 | 35 | 10 | 8 | 8 | 2 | occurred (slightly) | 2.0 |

## Claims

1. A method of manufacturing a vitreous silica crucible (10) comprising the step of heating and melting silica powder deposited on an inner surface of a rotating mold to vitrify the silica powder, wherein vapor-containing air with a relative humidity of 70% and a temperature of 25°C is introduced for 10 minutes at a flow rate of 120 m³/min or for 20 minutes at a flow rate of 80 m³/min right after the melting of the silica powder to manufacture a vitreous silica crucible where a region between 0.3 mm and 3 mm from an inner surface of the crucible has an OH group concentration and concentration gradient which decrease as a distance from the inner surface increases, wherein an amount of vapor is adjusted so as to obtain the OH group concentration and concentration gradient.

## Patentansprüche

1. Verfahren zur Herstellung eines Quarzglastiegels (10), umfassend den Schritt des Erhitzens und Schmelzens von Siliciumdioxidpulver, welches auf eine Innenfläche einer sich drehenden Form aufgebracht ist, um das Siliciumdioxidpulver zu Glas zu schmelzen, wobei Dampf enthaltende Luft mit einer relativen Feuchte von 70 % und einer Temperatur von 25 °C für 10 min mit einer Durchflussmenge von 120 m³/min oder für 20 min mit einer Durchflussmenge von 80 m³/min unmittelbar nach dem Schmelzen des Siliciumdioxidpulvers eingeleitet wird, um einen Quarzglastiegel herzustellen, bei dem ein Bereich zwischen 0,3 mm und 3 mm von einer Innenfläche des Tiegels aus eine OH-Gruppen-Konzentration und einen Konzentrationsgradienten aufweist, die mit zunehmendem Abstand von der Innenfläche abnehmen, wobei eine Dampfmenge so eingestellt wird, dass die OH-Gruppen-Konzentration und der Konzentrationsgradient erhalten werden.

## Revendications

1. Procédé de fabrication d'un creuset en verre de silice (10) comprenant une étape de chauffage et de fusion de poudre de silice déposée sur une surface intérieure d'un moule rotatif afin de vitrifier de la poudre de silice, de l'air contenant de la vapeur avec une humidité relative de 70 % et une température de 25° C étant introduit pendant 10 minutes avec un débit d'écoulement de 120 m³/min ou pendant 20 minutes avec un débit d'écoulement de 80 m³/min immédiatement après la fusion de la poudre de silice afin de produire un creuset en verre de silice où une zone située entre 0,3 mm et 3 mm depuis une surface intérieure du creuset présente une concentration en groupes OH et un gradient de concentration diminuant à mesure qu'augmente la distance depuis la surface intérieure, une teneur en vapeur étant réglée de manière à obtenir la concentration en groupes OH et le gradient de concentration.
